# EUROPEAN PATENT SPECIFICATION

(11) **EP 0 714 553 B1**
(45) Date of publication and mention of the grant of the patent: **03.11.1999**
(21) Application number: 94925280.3
(22) Date of filing: 15.08.1994
(51) Int. Cl.: H01L 21/60, H01L 21/56

(54) **METHOD OF FORMING ELECTRICALLY CONDUCTIVE POLYMER INTERCONNECTS ON ELECTRICAL SUBSTRATES**
METHODE ZUR FORMUNG VON ELEKTRISCH LEITENDEN POLYMERVERBINDUNGEN AUF ELEKTRONISCHEN SUBSTRATEN
PROCEDE DE FABRICATION D'INTERCONNEXIONS POLYMERES ELECTRIQUEMENT CONDUCTRICES SUR DES SUBSTRATS ELECTRIQUES

(30) Priority: 17.08.1993 US 107498
(43) Date of publication of application: 05.06.1996
(73) Proprietor: PFC Corporation, Billerica, MA 01821 (US)
(72) Inventor: KULESZA, Frank, W., Winchester, MA 01890 (US); ESTES, Richard, H., Pelham, NH 03076 (US)
(74) Representative: Hess, Peter K., Dipl.-Phys.
(86) International application number: US9409227
(87) International publication number: WO9505675

(56) References cited:
- EP-A- 0 473 976
- WO-A-91/09419
- WO-A-92/07378
- DE-A- 2 658 302
- JP-A- 63 151 031
- PATENT ABSTRACTS OF JAPAN vol. 6, no. 55 (E-101) 10 April 1982 & JP,A,56 167 340 (TOSHIBA) 23 December 1981
- PATENT ABSTRACTS OF JAPAN vol. 14, no. 222 (E-926) 10 May 1990 & JP,A,02 054 945 (TOSHIBA) 23 February 1990
- PATENT ABSTRACTS OF JAPAN vol. 12, no. 177 (E-613) 25 May 1988 & JP,A,62 283 644 (MITSUBISHI ELECTRIC) 9 December 1987

## Description

### Background of the Invention

Integrated circuits have had almost universal application to communication and military technologies for several years. Of increasing importance has been development of microcircuit wafers and methods for interconnection of the circuits by automated equipment. A primary limitation to application of microcircuit technology has been cost efficiency and reliability of interconnection of integrated circuits on chips because of the small size of the chips, which often require hundreds of connections to be made within each circuit.

One method of circuit interconnection is called flip chip bonding. Flip chip bonding can offer a shorter signal path and, therefore, more rapid communication between circuits than can other methods, such as tape automated bonding (TAB) or conventional wire bonding, because bond pads on flip chips are not restricted to the periphery of the chip, but rather are usually located at one face of the chip opposite a substrate. In one method of flip chip bonding, a chip or die is formed with the requisite integrated circuit and interconnect wiring required for interconnecting the circuit with other chip circuits on a circuit board, such as a separate printed circuit board or substrate. Bond pads are located at points of interconnection. Bumps are formed by plating of several layers of metals on the bond pads of the flip chips. Following deposition, the chip is heated to reflow the metals, thus causing surface tension of the deposit to form hemispherical solider "bumps." The flip chip is subsequently severed from the wafer of which it was a part and "flipped" for alignment with the bond pads of a substrate. These bumps are then contacted with the bond pads of the substrate and uniformly heated to simultaneously form interconnects between aligned bond pads of the flip chip and the substrate.

Use of metals to interconnect bond pads of flip chips and substrates has required, however, that passivation of the flip chip be accomplished by use of a metal barrier such as titanium (Ti), tungsten (W) or silicon nitride (Si₃N₄). Both the metal, as a passivation (or barrier) material, and ceramic, as a substrate material, are generally necessitated to allow sufficient heating to enable reflow of the solder bumps for interconnection between the flip chip and the substrate without consequential damage to either.

Fabrication of circuits using bumped flip chips have also been limited by the inability to visually inspect interconnections between the flip chip and the substrate. Further, the yield of finished mounted circuits can be detrimentally affected by failure of interconnects caused by the difference between the coefficients of thermal expansion of the various materials comprising the flip chip, the passivation layer, the solder bumps and the substrate. Also, melting of the solder bumps creates an electrically conductive flux as an undesirable byproduct which generally must be removed from between the substrate and the flip chip to allow proper operation of the finished circuit.

Problems of heat stress during fabrication have been addressed by various methods, such as by rapid application of heat to a bumped flip chip and rapid conduction of heat from the solder interconnects in order to minimize damage to flip chips, substrates and interconnections due to internal stresses caused by thermal expansion and contraction. However, this method is very expensive.

According to one another alternative suggested in the art, the use of conductive resin has been proposed to connect circuit elements with substrates. In the Patent Abstracts of Japan, vol. 12, no. 412(E-676) a technique is proposed to connect electrodes of a display panel with a wiring electrode of a flexible substrate. According to this technique, the wiring electrode is pressed on the electrode of the display panel by means of a compressing tool. During compression, a photocuring resin is injected through a nozzel and applied to the vicinity of the compressing tool and the overlapping, commen regions of the two electrodes. Then, ultraviolet rays are used to cure the resin. Thereafter, the compression tool is removed.

Another technique for establishing electrical contact between electrodes of a substrate and a circuit is disclosed in the DE-A-2658302. Accordingly, a conductive paste is printed on the connection pads of an integrated circuit. Before the printing paste is cured, the integrated circuit is flipped and applied to a substrate having bond pads in positional correspondence to the bond pads on the intergrated circuit. In this state, the paste is finally curred, so that an electrical contact is established between the bond pads of the integrated circuit and the bond pads of the substrate.

Yet another technique for forming electrical interconnections on bond pads of a substrate is known from prior art document WO 91/09419. According to this prior art approach, a method of forming interconnection bumps on bond pads of a substrate is known, comprising the steps of aligning a template over the substrate having openings which coincide with the pond pads of the substrate; forming bumps of electrically conductive polymer on said bond pads by directing electrically conductive polymer through said aligned openings of the template onto the bond pads; and removeing the template from the substrate.

In view of the above, there is still a need in the art for a method of interconnecting substrates such as flip chips, lead frames, multichip modules, and printed circuit boards, which is fast, cost-effective, and reliable on the one hand, and allows the bumping of bond pads with a very small pitch, on the other hand.

This object is solved by a method in accordance with claim 1.

In more detail, this object is solved by a method of forming interconnection bumps on bond pads of a substrate, comprising the steps of:
**a**. aligning a first template over the substrate, said first template having openings which coincide with a first set of bond pad of said substrate;
**b**. forming bumps of electically conductive polymer on said first set of bond pads by directing said electrically conductive polymer trough said alignend openings of said first template onto said first set of bond pads;
**c**. removing said first template from said substrate;
**d**. aligning a second template over said substrate, said second template having openings which coincide with a second set of bond pads of said substrate;
**e**. forming bumps of electrically conductive polymer on said second set of bond pads by directing said electrically conductive polymer trough said alignend openings of said second template onto said second set of bond pads;
   and
**f**. removing said second template from said substrate.

Further, an electrical circuit can be formed by the method of the invention. A second substrate is coated with an organic protective layer. Bond pads on the second substrate which coincide with the bond pads on the first substrate are exposed by laser ablation of the organic coating. The electrically conductive polymer bumps are then contacted with the bond pads of the second substrate to form the electrical circuit.

Formation of electrically conductive polymer bumps in two separate steps allows the formation of distinct polymer bumps in very close proximity to each other. Resulting distances, or pitch, between of at least about millimeters

Also, organic protective coatings can be selectively formed on substrates by removing portions of the coating by laser ablation. Bond pads on the substrate are thereby exposed for contact with electrically conductive polymer bumps on another substrate. Laser ablation allows precise control over the dimension of the openings formed in the organic protective layer. Also, residual coating remaining on the exposed bond pad is nominal when laser ablation is employed.

Further, forming an electrical circuit by a method which includes contacting electrically conductive bumps on a first substrate with bond pads of a second substrate having a selectively formed dielectric coating eliminates resultant void space between the substrates.
Consequently, the need to underfill void space is also eliminated. In addition, the organic protective layer provides improved strength of the resultant circuit and typically has an improved thermal conductivity relative to known underfill materials. The present method also forms circuits which are protected from attack by moisture and essentially eliminates the potential for formation of voids between the substrate of the circuit.

### Brief Description of the Drawing

Figure 1 is a plan view of one embodiment of a substrate employed by the method of the present invention.

Figure 2 is a section view of the substrate of Figure 1 taken along line II-II, and after a first template has been placed over the substrate.

Figure 3 is a section view of the substrate and template shown in Figure 2 after electrically conductive polymer bumps have been formed on a first set of bond pads at the substrate.

Figure 4 is a section view of the substrate and electrically conductive bumps as shown Figure 3, following removal of the template.

Figure 5 is a section view of the electrically conductive bumps and substrate shown in Figure 4, and of a second template placed over the substrate and electrically conductive polymer bumps.

Figure 6 is a section of view of the substrate and template shown in Figure 5 after an electrically conductive bump has been formed on a second set of the bond pads at the substrate.

Figure 7 is a section view of the electrically conductive bumps formed on the bond pads of the substrate after the second template has been removed.

Figure 8 is a section view of a second substrate suitable for use in an optional embodiment of the invention.

Figure 9 is a section view of the substrate shown in Figure 8 following coating of the substrate and bond pads of the substrate with an organic protective layer, according to the method of the present invention.

Figure 10 is a section view on the substrate and organic protective layer shown in Figure 9 following laser ablation of portions of the organic protective layer which cover the bond pads of the substrate.

Figure 11 is a section view of the substrate and laser ablated organic protective layer of Figure 10, and of the substrate of Figure 7, having electrically conductive polymer bumps at the bond pads of the substrate.

Figure 12 is a section view of an electrical circuit formed by contacting the electrically conductive polymer bumps at the first substrate with the bond pads at the second substrate, whereby void space between the first and second substrate is eliminated by the organic protective layer formed on the second substrate.

### Description of the Preferred Embodiments

The above features and other details of the invention, either as steps of the invention or as combinations of parts of the invention, will now be more particularly described with reference to the accompanying drawings and pointed out in the claims. It will be understood that the particular embodiments of the invention are shown by way of illustration and not as limitations of the invention. The principle feature of the invention may be employed in various embodiments without departing from the scope of the invention.

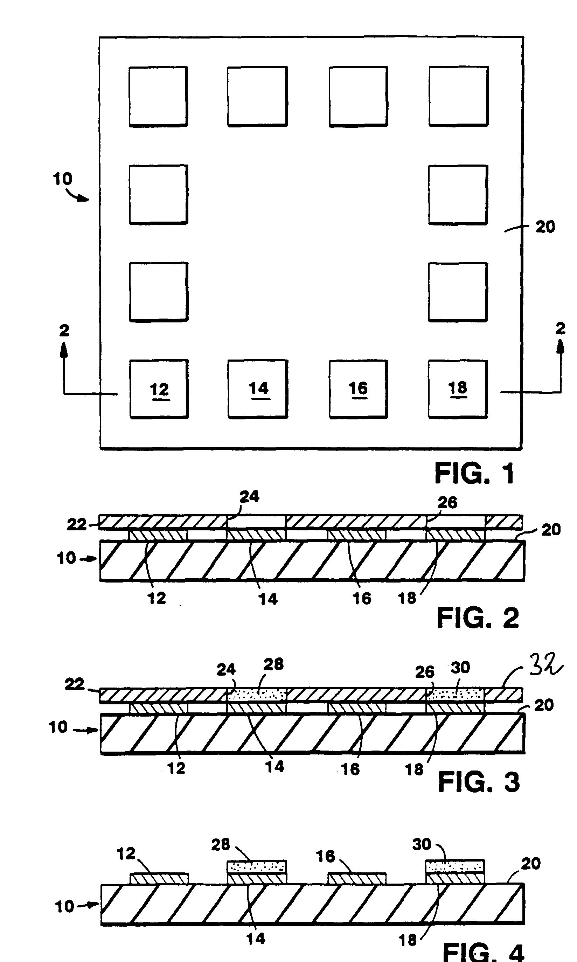

In one embodiment of the method of the present invention, a suitable substrate 10, such as that shown in Figure 1, has electrical bond pads 12,14,16,18 on upper planar surface 20 of the substrate. Examples of suitable substrates include flip chip dies, lead frames, multichip modules printed circuit boards, etc. Substrate 10 is formed of a suitable material, such as silicon , gallium arsenide, germanium or some other conventional semiconductor material.

As can be seen in figure 2, a first template 22 is placed over upper planer surface 20 of substrate. The First template 22 has openings 24,26 which are aligned with bond pads 14,18 which form a first set of the bond pads of the substrate 10, which is otherwise covered by template 22.

As defined herein, the first set of bond pads of substrate 10 are those bond pads which are exposed by placement of the first template on substrate 10. The second set of the bond pads, as defined herein, are those bond pads which are covered by placement of the first template on substrate 10. In a specific embodiment, at least one bond pad of the second set of bond pads is located between bond pads of the first set. As seen in Fig. 2, bond pads 14,18 represent the first set, and bond pads 12,16 represent the second set of the bond pads of substrate 10.

The first template 22 is suitable for screen printing electrically conductive polymer bumps onto the first set of bond pads of substrate 10. An example of a suitable template is a Laseretch stencil, commercially available from IRI.

Typically, the distance between the centers of bond pads of the first set from the centers of bond pads of the second set, also known as "pitch," is in the range of between about millimeters. Generally, the pitch between bond pads of the second set is greater than about two millimeters. It is to be understood, however, that the pitch between bond pads of the first set from bond pads of the second set can be greater than five millimeters. Also, bond pads on substrate 10 can be arranged peripherally, in a staggered arrangement, or in an array on upper planar surface of the substrate 10.

As shown in Figure 3, electrically conductive polymer bumps 28,30 are formed by directing the electrically conductive polymer through openings 24,26, respectively, of template 22 and onto the first set of the bond pads of substrate 10. Typically, electrically conductive bumps 28,30 are formed of a B-stage polymer or a thermoplastic polymer. The electrically conductive polymer bumps can be gold-filled, silver-filled, or filled with some other electrically conductive material. The polymer bumps 28,30 are about flush with an upper surface 32 of template 22. Template 22 is then removed from substrate 10, thereby leaving free-standing electrically conductive polymer bumps 28,30 on the first set of bond pads of substrate 10, as shown in Figure 4.

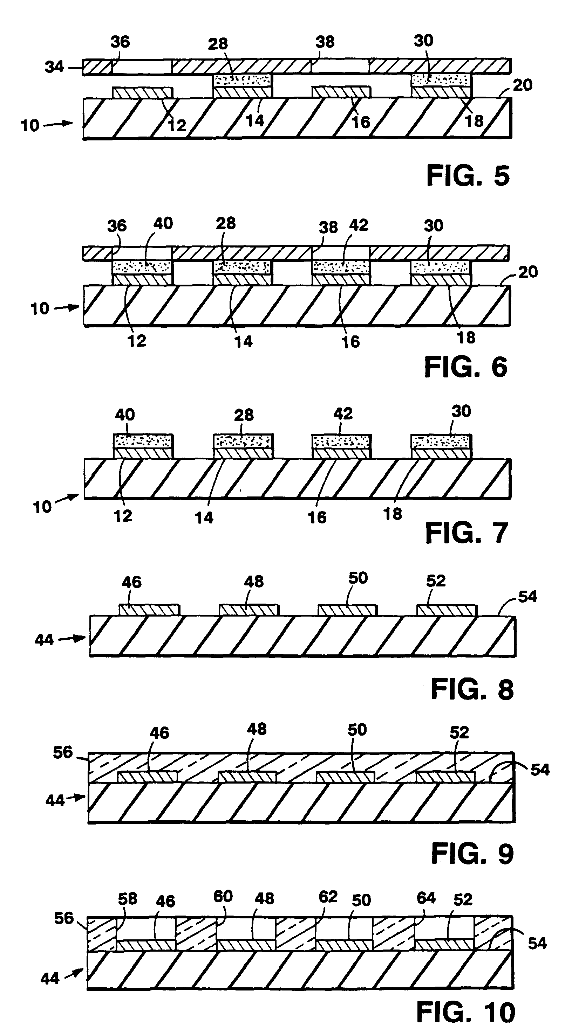

Second template 34 is then placed over substrate 10 and the electrically conductive polymer bumps 28,30 on the first set of the bond pads, as shown in Figure 5. Second template 34 includes openings 36,38. The openings of second template 34 are aligned with bond pads 12, 16 which represent the second set of the bond pads of substrate 10. Second template 34 is of the same type of construction, and is fabricated in the same way, as first template 22, except that the openings 36,38 of second template 34 are aligned with the second set of bond pads, rather than with the first set of bond pads.

As shown in Figure 6, electrically conductive polymer bumps 40,42 are formed by a suitable method, such as stenciling , whereby the electrically conductive polymer is directed through openings 36,38 of the second template 34 onto the second set of bond pads, which are bond pads 12,16. However, the height of the electrically conductive polymer bumps 40,42 formed on the second set of the bond pads is about the same as that of the electrically-conductive bumps formed on the first set of the bond pads. Any resultant differences in heights between the electrically conductive polymer bumps formed on the first set of bond pads and of the bumps formed on the second set of bond pads is small enough not to affect the formation of electrical interconnections between substrate 10 and a second substrate during fabrication of an electrical circuit. As shown in Figure 7, following removal of second template 34, electrically conductive polymer bumps 28,30,40,42 extend from the first and second sets of the bond pads of substrate 10.

Optionally, an organic protective layer, not shown, can be formed on substrate 10 either prior to, or following, formation of the electrically conductive polymer bumps, as described in U.S. 5,237,130, (cf. pg. 2a related WO 91/09491). Generally, however an organic protective layer will be formed on upper planar surface 20 of substrate 10 only as a heat sink, which is employed during operation of the fabricated electrical circuit that includes substrate 10.

As can be seen in Figure 8, second substrate 44 includes bond pads 46,48,50,52. Examples of suitable substrates include flip chips, lead frames, multichip modules and printed circuit boards. Bond pads 46,48,50,52 can be arranged in a peripheral pattern about upper surface 54 of substrate 44, in a staggered pattern, or in an array. Generally, bond pads 46,48,50,52 of second substrate 44 are arranged for alignment with electrically conductive polymer bumps 28,30,40,42 of first substrate 10.

Organic protective layer 56 is formed over substrate 44 and bond pads 46,48,50,52 of substrate 44 by a suitable method. Optionally, substrate 44 can be passivated with silicon nitride or an oxide layer, not shown, before formation of organic protective layer 56. The organic protective layer 56 is preferably a dielectric polymer. An example of an organic material suitable for application in the present invention is Epo-Tek^{®}, manufactured Epoxy Technology, Inc. The organic protective layer 56 passivates and thereby insulates and protects underlying surface 54 of second substrate 44.

Bond pads 46,48,50,52 of second substrate 44 are then exposed by laser ablation of organic protective layer 44 to form openings 58,60,62,64. Preferably, laser ablation is preformed by employing an Excimer-type laser. Preferably, the thickness of organic protective layer 56 is about equal to the combined thickness of bond pads 12,14,16,18,46,48,50,52 of first and second substrates, and of electrically conductive polymer bumps 28,30,40,42.

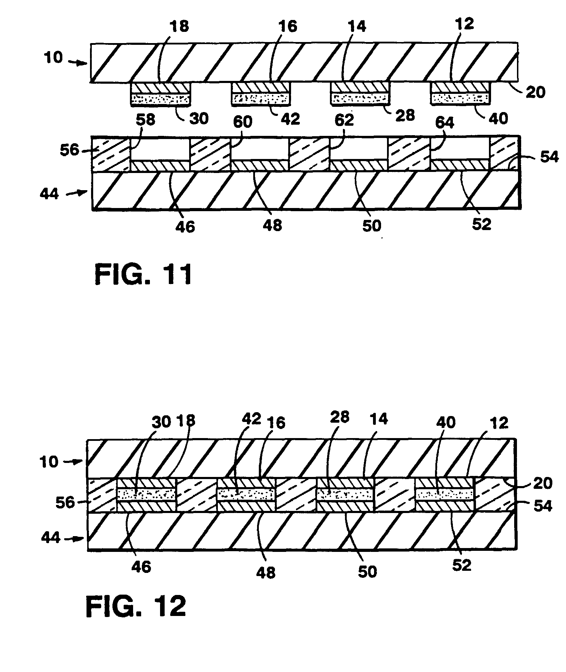

As shown in Figure 11, electrically conductive polymer bumps 28,30,40,42 at bond pads 12,14,16,18, of first substrate 10 are aligned with bond pads 46,48,50,52 of second substrate 44. Then, shown in Figure 12, electrically conductive polymer bumps 28,30,40,42 are contacted with bond pads 46,48,50,52 of second substrate 44, thereby forming an electrical circuit of the first and second substrates. Typically, an adhesive, not shown is formed on bond pads 46,48,50,52 of second substrate 44 before electrically conductive polymer bumps 28,30,40,42 are contacted to bond pads 46,48,50,52 of second substrate 44. Examples of adhesives which can be used includes theromsets, thermoplastics and polymer thick film. Adhesive is typically formed on substrate bond pads 46,48,50,52 by screen printing, templating, or by some other conventional method.

In a preferred embodiment, the first substrate 10 is aligned over the second substrate 44 by an aligner bonder, such as a Model M-8 aligner bonder, manufactured by Research Devices, Division of the America Optical Corporation.

While the discussion is directed to a single substrate, or to two substrates to form only one circuit, it is to be understood that the concept can be readily expanded to include more substrates, with bond pads on each, bonded to form a plurality of circuits.

## Claims

1. A method of forming interconnection bumps on bond pads of a substrate, comprising the steps of:
**a**. aligning a first template (22) over the substrate (10), said first template (22) having openings (24, 26) which coincide with a first set of bond pads (14, 18) of said substrate (10);
**b**. forming bumps (28, 30) of electrically conductive polymer on said first set of bond pads (14; 18) by directing said electrically conductive polymer trough said aligned openings (24, 26) of said first template (22) onto said first set of bond pads (14, 18);
**c**. removing said first template (22) from said substrate (10);
**d**. aligning a second template (34) over said substrate (10), said second template (34) having openings (36, 38) which coincide with a second set of bond pads (12, 16) of said substrate (10);
**e**. forming bumps (40, 42) of electrically conductive polymer on said second set of bond pads (12, 16) by directing said electrically conductive polymer through said aligned openings (36, 38) of said second template (34) onto said second set of bond pads (12, 16); and
**f**. removing said second template (34) from said substrate (10).

2. The method of claim 1, wherein said steps of aligning a first (22) and second template (34) comprises the steps of aligning first (22) and second (34) screen printing templates, or first (22) and second (34) stencilling templates.

3. The method of Claim 1 or 2, wherein the electrically conductive polymer bumps (28, 30 or 40, 42) are formed on the bond pads (14, 18 or 12, 16) of a flip chip.

4. The method of Claim 1 or 2, wherein the electrically conductive polymer bumps (28, 30 or 40, 42) are formed on the bond pads (14, 18 or 12, 16) of a multichip module.

5. The method of Claim 1 or 2, wherein the electrically conductive polymer bumps (28, 30 or 40, 42) are formed on the bond pads (14, 18 or 12, 16) of a lead frame.

6. The method of Claim 1 or 2, wherein the electrically conductive polymer bumps (28, 30 or 40, 42) are formed on the bond pads (14, 18 or 12, 16) of a printed circuit board.

7. The method of any of the preceding claims 1-6, wherein the electrically conductive polymer bumps (28, 30, 40, 42) are formed on the bond pads (12, 14, 16, 18) that are arranged in a peripheral pattern on the substrate (10).

8. The method of any of the preceding claims 1-6, wherein the electrically conductive bumps (28, 30, 40, 42) are formed on bond pads (12, 14, 16, 18) that are arranged in a staggered pattern on the substrate (10).

9. The method of any of the preceding claims 1-6, wherein the electrically conductive bumps (28, 30, 40, 42) are formed on bond pads (12, 14, 16, 18) that are arranged in an array on the substrate (10).

10. The method of any of the preceding claims 1-6, wherein at least one bond pad (14) of said first set is located between two bond pads (12, 16) of said second set.

11. The method of any of the preceding claims, wherein thermoplastic electrically conductive polymer bumps (28, 30, 40, 42) are formed on the bond pads (12, 14, 16, 18).

12. The method of any of the preceding claims 1-11, wherein B-stage polymer electrically conductive bumps (28, 30, 40, 42) are formed on the bond pads (12, 14, 16, 18).

13. The method of any of the preceding claims 1-11, wherein thermoset electrically conductive polymer bumps (28, 30, 40, 42) are formed on the bond pads (12, 14, 16, 18).

14. The method of any of the preceding claims, further including the steps of selectively forming an organic protective layer (56) on a second substrate (44) leaving bond pads (46, 48, 50, 52) thereon exposed, and then contacting the electrically conductive polymer bumps (28, 30, 40, 42) on said first substrate (10) with the pond pads (46, 48, 50, 52) of said second substrate (44), thereby forming electrical interconnections between said substrates (10, 44).

15. The method of Claim 14, wherein the organic protective layer (56) is selectively formed by coating the second substrate (44) with the organic protective layer (56) and then removing portions of the organic protective layer (56) which cover the bond pads (46, 48, 50, 52) of said second substrate (44).

16. The method of Claim 15, wherein the portions of the organic protective layer (56) which cover the bond pads (46, 48, 50, 52) are removed by laser ablation.

## Patentansprüche

1. Verfahren zur Bildung von Anschlußerhebungen auf Anschlußflächen eines Substrats mit den Schritten:
a) Ausrichten einer ersten Maske (22) über dem Substrat (10), wobei die erste Maske (22) Öffnungen (24, 26) aufweist, welche mit einem ersten Satz von Anschlußflächen (14, 18) des Substrats (10) übereinstimmen;
b) Formen von Erhebungen (28, 30) aus elektrisch leitfähigem Polymer auf dem ersten Satz von Anschlußflächen (14, 18), indem das elektrisch leitfähige Polymer durch die ausgerichteten Öffnungen (24, 26) der ersten Maske (22) auf den ersten Satz von Anschlußflächen (14, 18) geleitet wird;
c) Entfernen der ersten Maske (22) von dem Substrat (10);
d) Ausrichten einer zweiten Maske (34) über dem Substrat (10), wobei die zweite Maske (34) Öffnungen (36, 38) aufweist, welche mit einem zweiten Satz von Anschlußflächen (12, 16) des Substrats (10) übereinstimmen;
e) Formen von Erhebungen (40, 42) aus elektrisch leitfähigem Polymer auf dem zweiten Satz von Anschlußflächen (12, 16), indem das elektrisch leitfähige Polymer durch die ausgerichteten Öffnungen (36, 38) der zweiten Maske (34) auf den zweiten Satz von Anschlußflächen (12, 16) geleitet wird; und
f) Entfernen der zweiten Maske (34) von dem Substrat (10).

2. Verfahren nach Anspruch 1, wobei der Schritt des Ausrichtens der ersten (22) und zweiten Maske (34) die Schritte des Ausrichtens erster (22) und zweiter (34) Siebdruckmasken oder erster (22) und zweiter (34) Schablonenmasken umfaßt.

3. Verfahren nach Anspruch 1 oder 2, wobei die elektrisch leitfähigen Polymererhebungen (28, 30 oder 40, 42) auf den Anschlußflächen (14, 18 oder 12, 16) eines Flip-Chips gebildet werden.

4. Verfahren nach Anspruch 1 oder 2, wobei die elektrisch leitfähigen Polymererhebungen (28, 30 oder 40, 42) auf den Anschlußflächen (14, 18 oder 12, 16) eines Multi-Chip-Moduls gebildet werden.

5. Verfahren nach Anspruch 1 oder 2, wobei die elektrisch leitfähigen Polymererhebungen (28, 30 oder 40, 42) auf den Anschlußflächen (14, 18 oder 12, 16) eines Anschlußrahmens gebildet werden.

6. Verfahren nach Anspruch 1 oder 2, wobei die elektrisch leitfähigen Polymererhebungen (28, 30 oder 40, 42) auf den Anschlußflächen (14, 18 oder 12, 16) einer gedruckten Leiterplatte gebildet werden.

7. Verfahren nach einem der vorhergehenden Ansprüche 1 bis 6, wobei die elektrisch leitfähigen Polymererhebungen (28, 30, 40, 42) auf den Anschlußflächen (12, 14, 16, 18) gebildet werden, welche in einem Muster im Randbereich auf dem Substrat (10) angeordnet sind.

8. Verfahren nach einem der vorhergehenden Ansprüche 1 bis 6, wobei die elektrisch leitfähigen Erhebungen (28, 30, 40, 42) auf den Anschlußflächen (12, 14, 16, 18) gebildet sind, die in einem versetzten Muster auf dem Substrat (10) angeordnet sind.

9. Verfahren nach einem der vorhergehenden Ansprüche 1 bis 6, wobei die elektrisch leitfähigen Erhebungen (28, 30, 40, 42) auf Anschlußflächen (12, 14, 16, 18) geformt sind, die in einer regelmäßigen Anordnung auf dem Substrat angeordnet sind.

10. Verfahren nach einem der vorhergehenden Ansprüche 1 bis 6, wobei mindestens eine Anschlußfläche (14) des ersten Satzes zwischen zwei Anschlußflächen (12, 16) des zweiten Satzes positioniert ist.

11. Verfahren nach einem der vorhergehenden Ansprüche, wobei thermoplastische elektrisch leitfähige Polymererhebungen (28, 30, 40, 42) auf den Anschlußflächen (12, 14, 16, 18) gebildet werden.

12. Verfahren nach einem der vorhergehenden Ansprüche 1 bis 11, wobei die Erhebungen (28, 30, 40, 42) aus elektrisch leitfähigen Polymeren im B-Zustand auf den Anschlußflächen (12, 14, 16, 18) gebildet werden.

13. Verfahren nach einem der vorhergehenden Ansprüche 1 bis 11, wobei die Erhebungen (28, 30, 40, 42) auf den Anschlußflächen (12, 14, 16, 18) aus in Wärme aushärtbaren elektrisch leitfähigem Polymer gebildet werden.

14. Verfahren nach einem der vorhergehenden Ansprüche weiterhin umfassend die Schritte des selektiven Formens einer organischen Schutzschicht (56) auf einem zweiten Substrat (44), wobei Anschlußflächen (46, 48, 50, 52) darauf ungeschützt gelassen werden, und des anschließenden Kontaktierens der elektrisch leitfähigen Polymererhebungen (28, 30, 40, 42) auf dem ersten Substrat (10) mit den Anschlußflächen (46, 48, 50, 52) des zweiten Substrats (44), wodurch elektrische Verbindungen zwischen den Substraten (10, 44) gebildet werden.

15. Verfahren nach Anspruch 14, wobei die organische Schutzschicht (56) durch Beschichten des zweiten Substrats (44) mit der organischen Schutzschicht (56) und dem anschließenden Entfernen von Teilstücken der organischen Schutzschicht (56), welche die Anschlußflächen (46, 48, 50, 52) des zweiten Substrats (44) bedecken, selektiv gebildet wird.

16. Verfahren nach Anspruch 15, wobei die Bereiche der organischen Schutzschicht (56), welche die Anschlußflächen (46, 48, 50, 52) bedecken, mittels Laserablation entfernt werden.

## Revendications

1. Un procédé pour former des bossages d'interconnexion sur des plages de liaison d'un substrat, comprenant les étapes consistant à :
a. aligner un premier gabarit (22) sur le substrat (10), ce premier gabarit (22) comportant des ouvertures (24, 26) qui coïncident avec une première série de plages de liaison (14 18) du substrat (10);
b. former des bossages (28, 30) de polymère électriquement conducteur sur cette première série de plages de liaison (14, 18) en dirigeant le polymère électriquement conducteur au travers des ouvertures alignées (24, 26) du premier gabarit (22) jusque sur la première série de plages de liaison (14, 18);
c. retirer le premier gabarit (22) du substrat (10);
d. aligner un second gabarit (34) sur le substrat (10), ce second gabarit (34) possédant des ouvertures (36, 38) qui coïncident avec une seconde série de plages de liaison (12, 16) du substrat (10);
e. former des bossages (40, 42) de polymère électriquement conducteur sur la seconde série de plages de liaison (12, 16) en dirigeant le polymère électriquement conducteur au travers des ouvertures alignées (36, 38) du second gabarit (34) jusque sur la seconde série de plages de liaison (12, 16) ; et
f. retirer le second gabarit (34) du substrat (10).

2. Le procédé de la revendication 1, dans lequel les étapes d'alignement d'un premier (22) et d'un second (34) gabarit comprennent les étapes d'alignement d'un premier (22) et d'un second (34) gabarit de sérigraphie ou d'un premier (22) et d'un second (34) gabarit de pochoir.

3. Le procédé de la revendication 1 ou 2, dans lequel les bossages de polymère électriquement conducteur (28, 30 ou 40, 42) sont formés sur les plages de liaison (14, 18 ou 12, 16) d'une puce à bossages.

4. Le procédé de la revendication 1 ou 2, dans lequel les bossages de polymère électriquement conducteur (28, 30 ou 40, 42) sont formés sur les plages de liaison (14, 18 ou 12, 16) d'un module multipuce.

5. Le procédé de la revendication 1 ou 2, dans lequel les bossages de polymère électriquement conducteur (28, 30 ou 40, 42) sont formés sur les plages de liaison (14, 18 ou 12, 16) d'une grille de connexion.

6. Le procédé de la revendication 1 ou 2, dans lequel les bossages de polymère électriquement conducteur (28, 30 ou 40, 42) sont formés sur la plages de liaison (14, 18 ou 12, 16) d'une carte de circuit imprimé.

7. Le procédé de l'une des revendications précédentes 1 à 6, dans lequel les bossages de polymère électriquement conducteur (28, 30, 40, 42) sont formés sur les plages de liaison (12, 14, 16, 18) qui sont disposées suivant un motif périphérique sur le substrat (10).

8. Le procédé de l'une des revendications précédentes 1 à 6, dans lequel les bossages de polymère électriquement conducteur (28, 30, 40, 42) sont formés sur les plages de liaison (12, 14, 16, 18) qui sont disposées suivant un motif décalé sur le substrat (10).

9. Le procédé de l'une des revendications précédentes 1 à 6, dans lequel les bossages de polymère électriquement conducteur (28, 30, 40, 42) sont formés sur les plages de liaison (12, 14, 16, 18) qui sont disposées en un réseau sur le substrat (10).

10. Le procédé de l'une des revendications précédentes 1 à 6, dans lequel au moins une plage de liaison (14) de la première série est située entre deux plages de liaison (12, 16) de la seconde série.

11. Le procédé de l'une des revendications précédentes, dans lequel des bossages (28, 30, 40, 42) électriquement conducteurs en polymère thermoplastique sont formés sur les plages de liaison (12, 14, 16, 18).

12. Le procédé de l'une des revendications précédentes 1 à 11, dans lequel des bossages (28, 30, 40, 42) électriquement conducteurs en polymère à l'état B sont formés sur les plages de liaison (12, 14, 16, 18).

13. Le procédé de l'une des revendications précédentes 1 à 11, dans lequel des bossages (28, 30, 40, 42) en polymère électriquement conducteurs thermodurcis sont formés sur les plages de liaison (12, 14, 16, 18).

14. Le procédé de l'une des revendications précédentes, comprenant en outre les étapes de formation sélective d'une couche de protection organique (56) sur un second substrat (44) en laissant des plages de liaison (46, 48, 50, 52) exposées sur ce dernier, puis de mise en contact des bossages en polymère électriquement conducteur (28, 30, 40, 42) sur le premier substrat (10) avec les plages de liaison (46, 48, 50, 52) du second substrat (44), formant ainsi des interconnexions électriques entre ces substrats (10, 44).

15. Le procédé de la revendication 14, dans lequel la couche de protection organique (56) est sélectivement formée en revêtant le second substrat (44) de la couche de protection (56) puis en éliminant les parties de la couche de protection (56) qui recouvrent les plages de liaison (46, 48, 50, 52) du second substrat (44).

16. Le procédé de la revendication 15, dans lequel les parties de la couche de protection organique (56) qui recouvrent les plages de liaison (46, 48, 50, 52) sont enlevées par ablation au laser.
